# EUROPÄISCHE PATENTSCHRIFT

(11) **EP 2 944 506 B1**
(45) Veröffentlichungstag und Bekanntmachung des Hinweises auf die Patenterteilung: **28.08.2019**
(21) Anmeldenummer: 15166729.2
(22) Anmeldetag: 07.05.2015
(51) Int. Cl.: B60L 50/50, G01R 31/36, H02J 7/00

(54) **VERFAHREN ZUR BESTIMMUNG DES LADEZUSTANDS EINER TRAKTIONSBATTERIE EINES FLURFÖRDERZEUGS**
METHOD FOR DETERMINING THE CHARGE STATUS OF A TRACTION BATTERY OF AN INDUSTRIAL TRUCK
PROCÉDÉ DE DÉTERMINATION D'UN ÉTAT DE CHARGE D'UNE BATTERIE DE PROPULSION D'UN CHARIOT DE MANUTENTION

(30) Priorität: 16.05.2014 DE 102014106983
(43) Veröffentlichungstag der Anmeldung: 18.11.2015
(73) Patentinhaber: STILL GmbH, 22113 Hamburg (DE)
(72) Erfinder: Wede, Marc, 22941 Bargteheide (DE); Morawietz, Lutz, 01277 Dresden (DE)
(74) Vertreter: Patentship Patentanwaltsgesellschaft mbH

(56) Entgegenhaltungen:
- EP-A1- 2 096 453
- EP-A2- 2 689 954
- DE-T2- 60 204 327
- US-A- 5 895 440
- US-A1- 2004 100 225

## Beschreibung

Die Erfindung betrifft ein Verfahren zur Bestimmung des Ladezustands einer Traktionsbatterie nach dem Patentanspruch 1 und ein entsprechendes Flurförderzeug.

Bei batterie-elektrisch betriebenen Flurförderzeugen, beispielsweise Schubmast- oder Gegengewichtsgabelstaplern, ist es nach dem Stand der Technik bekannt, eine austauschbare und in ein Batteriefach einsetzbare Traktionsbatterie zu verwenden. Diese Traktionsbatterie ist in bekannter Ausführung als Blei-Säurebatterie oder auch als Blei-Gelbatterie ausgeführt.

Demgegenüber gibt es bereits in zunehmenden Maß Traktionsbatterien mit neuerer Technologie, insbesondere Lithium-Ionentechnologie. Diese zeichnen sich neben einer erhöhten Kapazität und erheblich höheren Energiedichte auch dadurch aus, dass ein Batteriesteuergerät in die Batterie zwangsläufig integriert ist und neben der Überwachung des Ladens und Entladens der Batterie auch einen Ladezustandswert der Batterie, auch bezeichnet als "State Of Charge", abgekürzt "SOC", zur Verfügung stellt. Dieser Ladezustandswert kann über eine geeignete Schnittstelle mit dem Flurförderzeug ausgetauscht werden und dem Fahrer angezeigt werden. Die Anzeige des Ladezustandswertes hilft dem Fahrer, den weiteren Einsatz des Flurförderzeugs zu planen bzw. einzuschätzen, wann ein erneutes Aufladen oder ein Tausch der Traktionsbatterie erforderlich wird. Vor allem soll durch die Anzeige verhindert werden, dass durch eine zu lange Betriebsdauer die Traktionsbatterie in den Zustand der Tiefentladung gerät und dadurch geschädigt wird.

Bei den bekannten Bleibatterien ist jedoch ein solches Batteriesteuergerät nicht üblich, hat sich als Standard nicht durchgesetzt und ist auch für den sicheren Betrieb der Bleibatterie an sich nicht erforderlich. Um den Ladezustandswert bzw. SOC einer Bleibatterie zu ermitteln, werden daher Spannungs- und Stromwerte der Bleibatterie, insbesondere eine Leerlaufspannung der Bleibatterie ohne Last durch Steuergeräte in dem Flurförderzeug erfasst.

Für die Bestimmung des Ladezustandswertes sind dabei verschiedene Verfahren bekannt. Beispielsweise in der DE 3 634 880 A1 wird ein bekanntes Verfahren beschrieben, bei dem erfasst wird, wenn keine Last an der Traktionsbatterie anliegt und in diesen Belastungspausen die Leerlaufspannung der Bleibatterie gemessen wird, um den Ladezustandswert zu erfassen.

Weiterhin ist ein Verfahren bekannt, beispielsweise aus der DE 3 910 868 C2, bei dem nach dem Abschalten der Bleibatterie vor dem Erreichen der Leerlaufspannung bzw. Ruhespannung eine Kennlinie durch Beobachtung der Spannung über der Zeit erfasst wird und aus dieser Kennlinie der Ladezustandswert bestimmt wird. Dieses Verfahren wird somit zu Beginn von Belastungspausen durchgeführt.

Als weiteres Verfahren zur Erfassung des Ladezustandswertes ist bekannt, Kennlinienfelder des Verhaltens der Batterie zu erstellen, mit deren Hilfe durch Strommessungen und Spannungsmessungen eine eindeutige Bestimmung des Ladezustandswertes ermöglicht wird. Ein Beispiel hierfür ist aus der DE 3 706 076 A1 bekannt.

Nachteilig ist bei allen diesen Verfahren nach dem Stand der Technik, dass nach jeder Inbetriebnahme des Flurförderzeugs, beispielsweise nach einem kürzeren oder längeren Abstellen des Flurförderzeugs durch die Bedienperson wegen einer anderen Tätigkeit, ein gewisser Zeitraum der Erfassung von Messwerten und Beobachtung der Batterie durch das Steuergerät des Flurförderzeugs erforderlich ist, bis ein gültiger Ladezustandswert bestimmt werden kann. Dies ist auch dadurch bedingt, dass viele Flurförderzeuge die elektrische Anlage im ausgeschalteten Zustand von der Traktionsbatterie trennen. Durch ein Steuergerät des Flurförderzeugs kann daher nicht erfasst werden, welche Veränderungen sich in Bezug auf die Traktionsbatterie ergeben. Dies kann etwa ein Tausch der Traktionsbatterie, ein Nachladen oder eine sonstige Veränderung wie auch eine Selbstentladung sein. Beispielsweise benötigen die beiden zuerst erläuterten Verfahren nach dem Stand der Technik ausreichend häufige Belastungspausen um einen hinreichend genauen Wert für den Belagerungszustand bilden zu können und bis zur Ermittlung eines Ladezustandswertes wird ein Zeitraum erforderlich, in dem mehrere, geeignete Belastungspausen auftreten. Bei heutigen Flurförderzeugen werden jedoch Antriebe eingesetzt, die etwa durch asynchrone Drehstrommaschinen mit entsprechender Leistungselektronik eine präzise Regelung der Geschwindigkeit und Drehzahl ermöglichen. Dabei erfolgt die Entnahme des Stroms aus der Batterie mit einem größeren Maß an Gleichmäßigkeit aufgrund der zwischengeschalteten Leistungselektronik und es treten Stromverläufe auf, die häufig das Erkennen von Belastungspausen nicht mehr zulassen. Dieses Problem wird verstärkt durch eine große Anzahl von zusätzlichen Verbrauchern, die moderne Flurförderzeuge aufweisen, die zu beliebigen Zeitpunkten kurz- oder langfristig eingeschaltet sein können und eine zusätzliche Stromentnahme aus der Traktionsbatterie bewirken.

Da ein zuverlässiger Wert für den Ladezustandswert erst nach einer gewissen Beobachtungsdauer mit beispielsweise einer Mehrzahl von Belastungspausen oder einem hinreichend langen Beobachten von Kennlinien möglich ist, ergeben sich Probleme nach einem Abschalten und außer Betrieb nehmen des Flurförderzeugs. Flurförderzeuge werden im Einsatz häufig für kurze oder längere Zeit abgeschaltet. Daneben gibt es auch Abschaltzeiten, in denen ein Nachladen der Traktionsbatterie erfolgt oder die Traktionsbatterie ausgetauscht wird, um im Mehrschichtbetrieb mit Wechselbatterien eine schnelle Einsatzbereitschaft wiederherzustellen. Es kommt im praktischen Betrieb auch vor, dass schlecht gewartete oder defekte Traktionsbatterien sowie entladene Traktionsbatterien versehentlich bei einem Tausch in das Flurförderzeug eingesetzt werden.

Nachteilig an dem zuvor geschilderten Stand der Technik ist, dass nach einem Abschalten eine richtige Anzeige des Ladezustandswertes erst mit zeitlicher Verzögerung zu erhalten ist bzw. die genannten Fälle eines fehlerhaften Batteriewechsels erst mit Verzögerung erkannt werden.

Die DE 602 04 327 T2, die EP 2 689 954 A2 und die EP 2 096 453 A1 betreffen Traktionsbatterien von Flurförderzeugen.

Der vorliegenden Erfindung liegt die Aufgabe zugrunde, ein Verfahren zur Bestimmung des Ladezustands einer Traktionsbatterie eines Flurförderzeugs zur Verfügung zu stellen, das die zuvor genannten Nachteile vermeidet und mit dem auch nach einer Betriebspause bzw. direkt nach einer Inbetriebnahme des Flurförderzeugs eine zuverlässige Bestimmung des Ladezustands möglich ist.

Diese Aufgabe wird durch ein Verfahren mit den Merkmalen des unabhängigen Patentanspruchs 1 und ein Flurförderzeug nach Patentanspruch 11 gelöst. Vorteilhafte Weiterbildungen der Erfindung sind in den Unteransprüchen angegeben.

Die Aufgabe wird erfindungsgemäß dadurch gelöst, dass bei einem Verfahren zur Bestimmung des Ladezustands einer Traktionsbatterie eines Flurförderzeugs, wobei von einer Steuerung des Flurförderzeugs ein Ladezustandswert bestimmt wird aus Parametern der Traktionsbatterie, insbesondere der Spannung der Batterie und/oder dem Batteriestrom, von der Steuerung vor einem Abschalten des Flurförderzeugs zumindest eine Abschaltspannung bestimmt und abgespeichert wird, ein Abschaltladezustandswert, der dem Ladezustandswert zum Zeitpunkt der Abschaltung entspricht, abgespeichert wird und eine Abschaltzeit des Flurförderzeugs erfasst wird und, dass von der Steuerung nach einem Einschalten des Flurförderzeugs die Batteriespannung als Einschaltspannung sowie eine Abschaltzeitdauer bis zum Einschalten aus der Abschaltzeit bestimmt werden sowie überprüft wird, ob die Einschaltspannung innerhalb eines Erwartungsbereiches liegt, wobei der Erwartungsbereich von der Abschaltspannung und der Abschaltzeitdauer abhängt, und wenn die Einschaltspannung innerhalb des Erwartungsbereiches liegt, der Abschaltladezustandswert als gültiger Ladezustandswert genommen wird sowie anderenfalls der Ladezustandswert neu bestimmt wird.

Durch das Verfahren erfolgt vorteilhaft eine Bewertung der über übliche Sensoren oder indirekt bestimmten Spannung der Traktionsbatterie, bezeichnet als Einschaltspannung, bei der Inbetriebnahme bzw. dem Einschalten des Flurförderzeugs im Hinblick auf zuvor aufgenommene Messdaten beim Abschalten. Unter dem Abschalten der Traktionsbatterie des Flurförderzeugs ist dabei stets ein Zustand zu verstehen, in dem die Traktionsbatterie so elektrisch von der Steuerung bzw. dem Flurförderzeug insgesamt getrennt wird, dass eine weitere Beobachtung des Ladezustandswert nicht mehr möglich ist, wie sie beispielsweise durch eine Schaltung eines Schützes in den Anschlussleitungen, oder das Abziehen eines Steckers erfolgen kann. Im einfachsten Fall kann dabei für die Abschaltspannung eine erkannte Leerlaufspannung genommen werden, die an den Batteriepolen anliegt, wenn keine Last bzw. kein Laststrom aus der Traktionsbatterie fließt. Diese kann beispielsweise fortlaufend abgespeichert werden und der letzte Wert entspricht dann der Abschaltspannung. Aus dem gemessenen bzw. berechneten und erwarteten Spannungs-Erholungsverhalten der Traktionsbatterie wird ein Erwartungsbereich für die Einschaltspannung festgelegt. Dieser Erwartungsbereich stellt sich als ein schmaler Streifen über der Zeit betrachtet dar, der einer Art "Spannungsschlauch" entspricht. Dabei ist zu erwarten, dass mit zunehmender Zeitdauer ohne Belastung die Spannung sich weiter erholt und ansteigt. Der Anstieg der Spannung ist dabei asymptotisch und nach einer Zeitspanne von ca. 2h für den Beispielsfall von Bleibatterien im Wesentlichen abgeschlossen. Dabei kann der Erwartungsbereich noch für thermische Eigenschaften, bekanntes Alterungsverhalten und eventuell eine Zellentechnologie der verwendeten Traktionsbatterie angepasst werden. Durch diese Prüfung, ob die Einschaltspannung innerhalb des Erwartungsbereiches liegt, kann festgestellt werden, ob noch die gleiche Traktionsbatterie ohne ein Nachladen in dem Flurförderzeug verblieben ist. Falls dies zutrifft, kann der zuvor abgespeichert Ladezustandswertes als neuer Ladezustandswert verwendet werden und einer bedienende Person bzw. einem Fahrer des Flurförderzeugs wird ohne zeitliche Verzögerung auch nach dem Einschalten der Ladezustandswert mit höherer Zuverlässigkeit angezeigt. Grundsätzlich kann die Bestimmung des Ladezustandswertes während des eingeschalteten Betriebszustandes des Flurförderzeugs nach allen im Stand der Technik bekannten Verfahren erfolgen.

Die Abschaltspannung und/oder die Einschaltspannung können Leerlaufspannungen der Traktionsbatterie ohne Last sein.

Dies ergibt zunächst ein sehr einfaches Verfahren, das ohne großen Aufwand umgesetzt werden kann, insbesondere wenn die letzte bekannte Leerlaufspannung abgespeichert wird und unter Inkaufnahme einer eventuellen Ungenauigkeit als Abschaltspannung genutzt wird.

In einer vorteilhaften Weiterführung des Verfahrens wird von der Steuerung ein Abschaltstrom vor dem Abschalten bestimmt und abgespeichert sowie hängt der Erwartungsbereich von dem Abschaltstrom ab.

Dadurch ergibt sich eine größere Genauigkeit. Der Verlauf der an den Klemmen der Traktionsbatterie anliegenden Spannung beim Wiedereinschalten bzw. der zeitliche Verlauf der Spannung nach einem Abschalten hängt in erheblichem Maße davon ab, mit welchem Laststrom die Traktionsbatterie im Moment des Abschaltens belastet war. Ausgehend von der zugleich bestimmten Spannung als Abschaltspannung kann dann ein genauer angepasster Erwartungsbereich für die Einschaltspannung beim Wiedereinschalten festgelegt werden. Dabei ist es denkbar, die Einschaltspannung als Leerlaufspannung zu bestimmen, bevor eine Last auf die Traktionsbatterie durch die Steuerung geschaltet wird. Die Abschaltspannung kann auch indirekt bestimmt werden, beispielsweise rechnerisch durch ein Summieren der durch die Steuerung aufgeschalteten Last, wenn eine direkte Bestimmung mit Sensormitteln nicht möglich ist.

Es können weitere Batterieparameter abgespeichert und/oder beim Einschalten erfasst werden.

Abhängig von der Batterietechnologie können weitere Daten zum Verhalten der Traktionsbatterie gespeichert werden, die für eine anschließende Bestimmung des Ladezustandswertes bzw. für eine Bewertung beim Wiedereinschalten benötigt werden.

Vorteilhaft wird bei einer Abschaltzeitdauer, kürzer als eine für einen Traktionsbatterietausch und/oder ein merkliches Nachladen der Traktionsbatterie erforderliche Mindestabschaltzeit, in jedem Fall der Abschaltladezustandswert als gültiger Ladezustandswert von der Steuerung genommen.

Bei einer kurzen Abschaltzeitdauer kann anhand der Plausibilität überprüft werden, ob ein Nachladen oder ein Tausch der Batterie überhaupt möglich ist. Wenn daher innerhalb einer Mindestabschaltzeit das Flurförderzeug wieder eingeschaltet wird, die so gewählt ist, dass ein Tausch nicht praktisch durchführbar ist bzw. durch ein Nachladen keine wesentliche Änderung der Spannung sich ergeben würde, kann das Verfahren auf die vorgeschlagene Art und Weise vereinfacht werden. In diesem Fall wird der Abschaltladezustandswert als gültiger Ladezustandswert übernommen.

Die Mindestabschaltzeit kann zwischen 10 und 120 Sekunden liegen, insbesondere 30 Sekunden betragen.

Einen unteren Wert des Erwartungsbereiches kann die Abschaltspannung bilden.

Im Regelfall steigt während einer Abschaltzeitdauer durch die Erholung der Batteriespannung die an den Klemmen gemessene Spannung der Traktionsbatterie an. Ganz grundsätzlich und unabhängig davon, wie der untere Wert des Erwartungsbereiches im Zeitverlauf festgelegt wird, kann bei einer niedrigeren Spannung als Einschaltspannung abgeschätzt werden, dass eine Entladung in der Abschaltzeitdauer stattfand. Dies ist je nach Ausführung der elektrischen Anlage des Flurförderzeugs eventuell möglich. Eine weitere mögliche Ursache ist eine Selbstentladung, bei der auch über die Dauer der Abschaltzeitdauer überprüft werden kann, ob dies plausibel sein kann. Schließlich kann als Grund einer niedrigeren Einschaltspannung angenommen werden, dass ein Tausch mit einer Traktionsbatterie stattfand, die eine niedrigere Spannung hat. Letzteres ist denkbar, wenn versehentlich eine weiter entladene Traktionsbatterie oder eine Traktionsbatterie mit einer anderen Zellentechnologie getauscht wurde, die grundsätzlich eine geringere Spannung aufweist. In allen diesen Fällen erfolgt eine Neubestimmung des Ladezustandswertes.

Vorteilhaft wird ein oberer Wert des Erwartungsbereiches durch einen über der Zeit ansteigenden Spannungswert gebildet, entsprechend der theoretisch maximal möglichen Erholung der Spannung der Traktionsbatterie ausgehend von der Abschaltspannung.

Unabhängig davon, wie der obere Wert des Erwartungsbereiches definiert wird kann davon ausgegangen werden, dass die Traktionsbatterie nachgeladen oder getauscht wurde, wenn die Einschaltspannung oberhalb des Erwartungsbereiches liegt. In diesem Fall ist eine Neubestimmung des Ladezustandswertes erforderlich.

Der Verlauf des Erwartungsbereiches über der Zeit kann von der Steuerung berechnet werden.

In günstiger Ausgestaltung ist der Verlauf des Erwartungsbereiches über der Zeit für eine Mehrzahl von Werten des Abschaltstroms, der Abschaltzeitdauer sowie gegebenenfalls eines Abschaltstroms abgespeichert in der Steuerung.

Durch empirisch gemessene Erwartungsbereiche kann auf recht einfache Art und Weise das Verhalten einer Traktionsbatterie bestimmt werden. Dabei ist es eventuell denkbar durch eine bestimmte Anzahl von Werten dazwischen liegende Werte für den Abschaltstrom zu interpolieren.

Durch das beschriebene Verfahren ist es auch denkbar, Rückschlüsse auf Fehler in der elektrischen Anlage und/oder der Traktionsbatterie machen. Durch diese können eine Fehlerdiagnose unterstützt sowie Wartungs- und Reparaturmaßnahmen abgeleitet werden.

Die Aufgabe wird auch gelöst durch ein Flurförderzeug mit einer Traktionsbatterie und einer Steuerung zur Erfassung des Ladezustands der Traktionsbatterie, wobei die Steuerung ein zuvor beschriebenes Verfahren durchführt.

Das Flurförderzeug weist die bereits zuvor beschriebenen Vorteile auf.

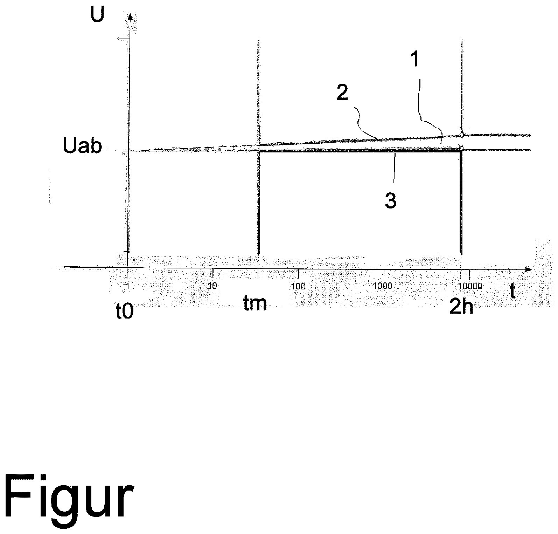

Weitere Vorteile und Einzelheiten der Erfindung werden anhand des in der schematischen Figur dargestellten Ausführungsbeispiels näher erläutert. Hierbei zeigt die Figur an dem Beispiel einer PzS-Traktionsbatterie bei einer Umgebungstemperatur von 20° C schematisch den Erwartungsbereich 1 der Einschaltspannung der Traktionsbatterie über der Zeit in einer logarithmischen Darstellung der als Rechtsachse aufgetragenen Zeit t. In der Hochachse ist die Batteriespannung U aufgetragen.

Zum Zeitpunkt des Abschaltens t0 werden eine Abschaltspannung Uab sowie ein Abschaltladezustandswert bestimmt und abgespeichert. Die Zeit t entspricht somit der Abschaltzeitdauer seit der Abschaltzeit t0. Der Erwartungsbereich 1 steigt entsprechend der Erholung der Batteriespannung mit einem oberen Wert 2 asymptotisch an bis zu einer Zeitdauer von ungefähr 2 Stunden, entsprechend einem linearen Anstieg in der logarithmischen Darstellung. Zusammen mit einem unteren Wert 3, im vorliegenden Beispiel entsprechend der Abschaltspannung Uab, ergibt sich ein "Spannungsschlauch" für den Erwartungsbereich 1, der sich langsam öffnet. Wenn ein Einschalten früher als die Mindestabschaltzeit tm, im vorliegenden Beispiel ca. 30 Sekunden, erfolgt, wird der Abschaltladezustandswert als gültiger Ladezustandswert übernommen, da davon auszugehen ist, dass kein Nachladen oder Tauschen der Traktionsbatterie erfolgen konnte.

Wenn die Einschaltspannung nach einer Abschaltzeitdauer oberhalb oder unterhalb des Erwartungsbereiches 1 liegt, so erfolgt eine Neubestimmung des Ladezustandswertes und wird dieser nicht übernommen. Dadurch steht einer Bedienperson bzw. einem Fahrer in der statistischen Mehrzahl der Fälle schnell und zuverlässig eine korrekte Anzeige des Ladezustandswertes auch nach einer kurzen Außerbetriebnahme des Fahrzeuges zur Verfügung.

## Patentansprüche

1. Verfahren zur Bestimmung des Ladezustands einer Traktionsbatterie eines Flurförderzeugs, wobei von einer Steuerung des Flurförderzeugs ein Ladezustandswert bestimmt wird aus Parametern der Traktionsbatterie, insbesondere der Spannung der Batterie und/oder dem Batteriestrom,
**dadurch gekennzeichnet,**
**dass** von der Steuerung vor einem Abschalten des Flurförderzeugs zumindest eine Abschaltspannung bestimmt und abgespeichert wird, ein Abschaltladezustandswert, der dem Ladezustand zum Zeitpunkt der Abschaltung entspricht, abgespeichert wird und
eine Abschaltzeit (t0) des Flurförderzeugs erfasst wird und,
**dass** von der Steuerung nach einem Einschalten des Flurförderzeugs die Batteriespannung als Einschaltspannung sowie eine Abschaltzeitdauer (t) bis zum Einschalten aus der Abschaltzeit (t0) bestimmt werden sowie überprüft wird, ob die Einschaltspannung innerhalb eines Erwartungsbereiches (1) liegt, wobei der Erwartungsbereich (1) von der Abschaltspannung und der Abschaltzeitdauer (t) abhängt, und wenn die Einschaltspannung innerhalb des Erwartungsbereiches (1) liegt, der Abschaltladezustandswert als gültiger Ladezustandswert genommen wird sowie anderenfalls der Ladezustandswert neu bestimmt wird.

2. Verfahren nach Anspruch 1,
**dadurch gekennzeichnet,**
**dass** die die Abschaltspannung und/oder die Einschaltspannung Leerlaufspannungen der Traktionsbatterie ohne Last sind.

3. Verfahren nach Anspruch 1 oder 2,
**dadurch gekennzeichnet,**
**dass** von der Steuerung ein Abschaltstrom vor dem Abschalten bestimmt und abgespeichert wird sowie der Erwartungsbereich (1) von dem Abschaltstrom abhängt.

4. Verfahren nach einem der Ansprüche 1 bis 3,
**dadurch gekennzeichnet,**
**dass** weitere Batterieparameter abgespeichert werden und/oder beim Einschalten erfasst werden.

5. Verfahren nach einem der Ansprüche 1 bis 4,
**dadurch gekennzeichnet,**
**dass** bei einer Abschaltzeitdauer, kürzer als ein für einen Traktionsbatterietausch und/oder ein merkliches Nachladen der Traktionsbatterie erforderliche Mindestabschaltzeit (tm), in jedem Fall der Abschaltladezustandswert als gültiger Ladezustandswert von der Steuerung genommen wird.

6. Verfahren nach Anspruch 5,
**dadurch gekennzeichnet,**
**dass** die Mindestabschaltzeit (tm) zwischen 10 und 120 Sekunden liegt, insbesondere 30 Sekunden beträgt.

7. Verfahren nach einem der Ansprüche 1 bis 6,
**dadurch gekennzeichnet,**
**dass** ein unterer Wert (3) des Erwartungsbereiches (1) die Abschaltspannung bildet.

8. Verfahren nach einem der Ansprüche 1 bis 7,
**dadurch gekennzeichnet,**
**dass** ein oberer Wert (2) des Erwartungsbereiches (1) durch einen über der Zeit ansteigenden Spannungswert gebildet wird, entsprechend der theoretisch maximal möglichen Erholung der Spannung der Traktionsbatterie ausgehend von der Abschaltspannung.

9. Verfahren nach einem der Ansprüche 1 bis 8,
**dadurch gekennzeichnet,**
**dass** der Verlauf des Erwartungsbereiches (1) über der Zeit (t) von der Steuerung berechnet wird.

10. Verfahren nach einem der Ansprüche 1 bis 9,
**dadurch gekennzeichnet,**
**dass** der Verlauf des Erwartungsbereiches (1) über der Zeit (t) für eine Mehrzahl von Werten des Abschaltstroms, der Abschaltzeitdauer (t) sowie gegebenenfalls eines Abschaltstroms abgespeichert ist in der Steuerung.

11. Flurförderzeug mit einer Traktionsbatterie und einer Steuerung zur Erfassung des Ladezustands der Traktionsbatterie, wobei von der Steuerung des Flurförderzeugs ein Ladezustandswert aus Parametern der Traktionsbatterie, insbesondere der Spannung der Batterie und/oder dem Batteriestrom, bestimmt werden kann, wobei die Steuerung ein Verfahren nach einem der Ansprüche zuvor durchführt.

## Claims

1. Method for determining the state of charge of a traction battery of an industrial truck, wherein a state of charge value is determined from parameters of the traction battery, in particular the voltage of the battery and/or the battery current, by a control system of the industrial truck,
**characterized in that**
at least one switch-off voltage is determined and stored by the control system before the industrial truck is switched off, a switch-off state of charge value corresponding to the state of charge at the time of switch-off is stored and
a switch-off time (t0) of the industrial truck is detected and
**in that**, after the industrial truck is switched on, the control system determines the battery voltage as switch-on voltage and determines a switch-off period (t) until switch-on from the switch-off time (t0) and checks to determine whether the switch-on voltage is within an expected range (1), wherein the expected range (1) depends on the switch-off voltage and the switch-off period (t), and if the switch-on voltage is within the expected range (1), the switch-off state of charge value is taken as valid state of charge value and otherwise the state of charge value is determined again.

2. Method according to Claim 1,
**characterized in that**
the switch-off voltage and/or the switch-on voltage are open-circuit voltages of the traction battery without load.

3. Method according to Claim 1 or 2,
**characterized in that**
a switch-off current is determined and stored by the control system before switch-off and the expected range (1) depends on the switch-of current.

4. Method according to one of Claims 1 to 3,
**characterized in that**
further battery parameters are stored and/or detected during switch-on.

5. Method according to one of Claims 1 to 4,
**characterized in that**,
in the case of a switch-off period shorter than a minimum switch-off time (tm) required for a traction battery exchange and/or notable recharging of the traction battery, in each case the switch-off state of charge value is taken as valid state of charge value by the control system.

6. Method according to Claim 5,
**characterized in that**
the minimum switch-off time (tm) is between 10 and 120 seconds, in particular 30 seconds.

7. Method according to one of Claims 1 to 6,
**characterized in that**
a lower value (3) of the expected range (1) forms the switch-off voltage.

8. Method according to one of Claims 1 to 7,
**characterized in that**
an upper value (2) of the expected range (1) is formed by a voltage value that increases over time, according to the theoretically maximum possible recovery of the voltage of the traction battery proceeding from the switch-off voltage.

9. Method according to one of Claims 1 to 8,
**characterized in that**
the profile of the expected range (1) over time (t) is calculated by the control system.

10. Method according to one of Claims 1 to 9,
**characterized in that**
the profile of the expected range (1) over time (t) for a plurality of values of the switch-off current, the switch-off period (t) and possibly a switch-off current is stored in the control system.

11. Industrial truck having a traction battery and a control system for detecting the state of charge of the traction battery, wherein a state of charge value can be determined from parameters of the traction battery, in particular the voltage of the battery and/or the battery current, by the control system of the industrial truck, wherein the control system carries out a method according to one of the preceding claims.

## Revendications

1. Procédé de détermination de l'état de charge d'une batterie de traction d'un chariot de manutention, une valeur d'état de charge étant déterminée par une commande du chariot de manutention à partir de paramètres de la batterie de traction, notamment à partir de la tension de la batterie et/ou du courant de batterie,
**caractérisé en ce**
**que** la commande, avant une mise hors circuit du chariot de manutention, détermine et met en mémoire au moins une tension de mise hors circuit, met en mémoire une valeur d'état de charge de mise hors circuit, laquelle correspond à l'état de charge au moment de la mise hors circuit, et acquiert un temps de mise hors circuit (t0) du chariot de manutention et
**que** la commande, après une mise en circuit du chariot de manutention, détermine la tension de batterie en tant que tension de mise en circuit ainsi qu'une durée de mise hors circuit (t) jusqu'à la mise en circuit à partir du temps de mise hors circuit (t0), et contrôle si la tension de mise en circuit se trouve à l'intérieur d'une plage escomptée (1), la plage escomptée (1) étant dépendante de la tension de mise hors circuit et de la durée de mise hors circuit (t), et lorsque la tension de mise en circuit se trouve à l'intérieur de la plage escomptée (1), la valeur d'état de charge de mise hors circuit est adoptée comme valeur d'état de charge valide et, le cas contraire, la valeur d'état de charge est redéterminée.

2. Procédé selon la revendication 1, **caractérisé en ce que** la tension de mise hors circuit et/ou la tension de mise en circuit sont des tensions à vide de la batterie de traction en l'absence de charge.

3. Procédé selon la revendication 1 ou 2,
**caractérisé en ce que** la commande détermine et met en mémoire un courant de mise hors circuit avant la mise hors circuit et la plage escomptée (1) est dépendante du courant de mise hors circuit.

4. Procédé selon l'une des revendications 1 à 3,
**caractérisé en ce que** des paramètres de batterie supplémentaires sont mis en mémoire et/ou acquis lors de la mise en circuit.

5. Procédé selon l'une des revendications 1 à 4,
**caractérisé en ce que** dans le cas d'une durée de mise hors circuit plus courte qu'un temps de mise hors circuit minimal (tm) nécessaire pour un remplacement de la batterie de traction et/ou une recharge évidente de la batterie de traction, la valeur d'état de charge de mise hors circuit est dans tous les cas adoptée par la commande comme valeur d'état de charge valide.

6. Procédé selon la revendication 5, **caractérisé en ce que** le temps de mise hors circuit minimal (tm) est compris entre 10 et 120 secondes, notamment égal à 30 secondes.

7. Procédé selon l'une des revendications 1 à 6,
**caractérisé en ce qu'**une valeur basse (3) de la plage escomptée (1) forme la tension de mise hors circuit.

8. Procédé selon l'une des revendications 1 à 7,
**caractérisé en ce qu'**une valeur haute (2) de la plage escomptée (1) est formée par une valeur de tension qui croît dans le temps, conformément à la régénération théorique maximale possible de la tension de la batterie de traction à partir de la tension de mise hors circuit.

9. Procédé selon l'une des revendications 1 à 8,
**caractérisé en ce que** la courbe de la plage escomptée (1) en fonction du temps (t) est calculée par la commande.

10. Procédé selon l'une des revendications 1 à 9,
**caractérisé en ce que** la courbe de la plage escomptée (1) en fonction du temps (t) pour une pluralité de valeurs du courant de mise hors circuit, de la durée de mise hors circuit (t) et éventuellement d'un courant de mise hors circuit est mise en mémoire dans la commande.

11. Chariot de manutention équipé d'une batterie de traction et d'une commande destinée à acquérir l'état de charge de la batterie de traction, une valeur d'état de charge pouvant être déterminée par la commande du chariot de manutention à partir de paramètres de la batterie de traction, notamment à partir de la tension de la batterie et/ou du courant de batterie, la commande mettant en oeuvre un procédé selon l'une des revendications précédentes.
